# FASCICULE DE BREVET EUROPEEN

(11) **EP 4 290 245 B1**
(45) Date de publication et mention de la délivrance du brevet: **19.03.2025**
(21) Numéro de dépôt: 23178169.1
(22) Date de dépôt: 08.06.2023
(51) Int. Cl.: G01R 19/165, B60L 53/10, G01R 31/66, H02J 7/00

(54) **DISPOSITIF DE DETECTION D'UNE COUPURE ET/OU D'UNE ANOMALIE D'UNE CONNEXION**
VORRICHTUNG ZUR ERKENNUNG EINER UNTERBRECHUNG UND/ODER ANOMALIE EINER VERBINDUNG
DEVICE FOR DETECTING A BREAK AND/OR AN ANOMALY IN A CONNECTION

(30) Priorité: 10.06.2022 FR 2205585
(43) Date de publication de la demande: 13.12.2023
(73) Titulaire: DELTA DORE, 35270 Bonnemain (FR)
(72) Inventeur: LE TUTOUR, Jean, 35270 Bonnemain (FR); CHABANNES, André, 35270 Bonnemain (FR); ETORRE, Guillaume, 35270 Bonnemain (FR)
(74) Mandataire: Cabinet Le Guen Maillet

(56) Documents cités:
- US-A1- 2009 102 433
- US-A1- 2010 079 105
- US-A1- 2021 048 485
- US-A1- 2021 237 607

## Description

### DOMAINE TECHNIQUE

La présente invention concerne un dispositif de détection d'une coupure et/ou d'une anomalie d'une connexion entre une borne de recharge et un véhicule électrique

### ETAT DE LA TECHNIQUE ANTERIEURE

Les bornes de recharge d'un véhicule sont classiquement équipées d'une prise femelle normalisée tandis que les véhicules sont équipés d'une prise mâle. La prise femelle de la borne ou station de recharge est fixée soit directement sur la borne, soit au bout d'un câble flexible attaché de manière permanente à la borne par l'autre extrémité.

Les prises sont par exemple conformes à la norme CEI 62196 Type 2.

Les prises conformes à la norme CEI 62196 Type 2 comportent sept liens de connexion : un lien de connexion de proximité PP (acronyme de Proximity Pilot en anglais), un lien de contrôle CP (acronyme de Control Pilot en anglais), un lien de mise à la terre PE (acronyme de Protective Earth en anglais) et quatre broches d'alimentation selon le mode de fonctionnement. Le lien de connexion PP permet la signalisation d'une pré-insertion et le lien de connexion CP permet la signalisation d'une post-insertion.

Les prises ont une forme circulaire avec un méplat sur la partie haute qui sert de détrompeur. De par leur conception, les contacts ne peuvent pas être touchés par un doigt de test standardisé. Depuis la deuxième édition de la norme, une protection supplémentaire contre le toucher des contacts peut être assurée en option par des obturateurs. Lorsqu'elle est insérée dans un socle de véhicule, la prise est verrouillée en place par un mécanisme spécial particulier. Le même mécanisme est utilisé par le socle de la borne pour verrouiller la fiche en place.

L'intensité de courant maximale prévue par la norme IEC 62196-2 est de 63 A en triphasé et de 70 A en monophasé. Cette intensité maximale peut, lors de déconnexions brutales de la prise, être dangereuse pour les utilisateurs.

Le document US 2021/237607 A1 divulgue un circuit permettant de détecter l'anomalie d'un point pilote de contrôle d'une pile de chargement lorsqu'un véhicule électrique y est électriquement connecté, et de transmettre le signal pilote de contrôle détecté à un circuit de contrôle.

La présente invention vise à sécuriser les utilisateurs lors des déconnexions des prises véhicules aux bornes de recharge de véhicules.

### EXPOSE DE L'INVENTION

A cette fin, selon un premier aspect, l'invention propose un dispositif de détection d'une coupure et/ou d'anomalie d'une connexion entre une borne de recharge et un véhicule électrique, la connexion comportant au moins un lien de contrôle, un lien de mise à la terre, des broches d'alimentation, le lien de contrôle permettant la signalisation d'une post-insertion, caractérisé en ce que le dispositif de détection comporte :
- un microcontrôleur configuré pour mesurer la tension sur le lien de contrôle et pour commander la fermeture ou l'ouverture d'un premier interrupteur afin d'autoriser ou non la fourniture d'énergie électrique par les broches d'alimentation,
- un circuit électronique, distinct du microcontrôleur, pour mesurer la tension sur le lien de contrôle et commander la fermeture ou l'ouverture d'un second interrupteur pour autoriser ou non la fourniture en énergie électrique par les broches d'alimentation, lesdits premier et second interrupteurs étant montés en série.

Ainsi, la présente invention permet de couper l'alimentation du véhicule électrique même en cas de défaillance du microcontrôleur et/ou du premier interrupteur ou lorsqu'une valeur de tension présente sur le lien de contrôle est anormale.

En utilisant un circuit électronique en complément du microcontrôleur, une latence minimale de réponse peut être obtenue. Ceci est particulièrement avantageux lorsque le microcontrôleur traite d'autres tâches que la surveillance de la tension sur le lien de contrôle.

Selon un mode particulier de l'invention, la connexion entre la borne de recharge et le véhicule électrique comporte en outre un lien de connexion de proximité permettant une signalisation d'une pré-insertion et :
- le microcontrôleur est configuré pour mesurer la tension sur le lien de connexion de proximité et pour commander la fermeture ou l'ouverture du premier interrupteur pour autoriser ou non la fourniture en énergie électrique par les broches d'alimentation,
- le circuit électronique mesure la tension sur le lien de connexion de proximité et commande la fermeture ou l'ouverture du second interrupteur pour autoriser ou non la fourniture en énergie électrique par les broches d'alimentation.

Ainsi, la présente invention permet de couper très rapidement l'alimentation du véhicule même si le microcontrôleur présente un délai d'exécution logiciel trop important ou un disfonctionnement.

Selon un mode particulier de l'invention, lesdits premier et second interrupteurs montés en série commandent un troisième interrupteur pour autoriser ou non la fourniture en énergie électrique par les broches d'alimentation.

Ainsi, la présente invention permet de bénéficier d'une augmentation du niveau de sécurité.

Selon un mode particulier de l'invention, le circuit électronique comporte un premier comparateur pour comparer le signal du lien de contrôle à une première tension, un second comparateur pour comparer le signal sur le lien de connexion de proximité à une seconde tension et une fonction logique non ou pour combiner les signaux de sortie des premier et second comparateurs.

Ainsi, la présente invention permet de prendre en compte ces deux informations de manière automatique sans utilisation d'un composant numérique de type microcontrôleur présentant un risque de fiabilité logicielle ou un délai de traitement important.

Selon un mode particulier de l'invention, le dispositif de détection comporte un autre interrupteur, l'ouverture et la fermeture de l'autre interrupteur étant commandées par le microcontrôleur en fonction du fait que la prise femelle de la borne de recharge est fixée directement sur la borne de recharge ou est au bout d'un câble flexible attaché de manière permanente à la borne de recharge par l'autre extrémité.

### BREVE DESCRIPTION DES DESSINS

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
[Fig. 1] illustre schématiquement l'architecture d'un système de recharge d'un véhicule électrique ;
[Fig. 2a] représente un schéma bloc d'un premier exemple de réalisation d'un dispositif de détection d'une coupure d'une connexion entre une borne de recharge et un véhicule électrique ;
[Fig. 2b] représente un schéma bloc d'un second exemple de réalisation d'un dispositif de détection d'une coupure d'une connexion entre une borne de recharge et un véhicule électrique ;
[Fig. 3] représente un exemple de réalisation d'un circuit de gestion de la présence ou non d'un lien de connexion PP permettant la signalisation d'une pré-insertion d'une prise ;
[Fig. 4] représente un exemple de réalisation d'un circuit de détection d'une coupure d'une connexion entre une borne de recharge et un véhicule électrique ;
[Fig. 5] représente un exemple de signaux électriques du circuit de détection d'une coupure d'une connexion entre une borne de recharge et un véhicule électrique.

### EXPOSE DETAILLE DE MODES DE REALISATION

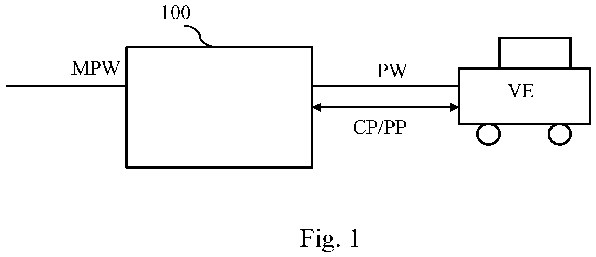

La Fig. 1 illustre schématiquement l'architecture d'un système de recharge d'un véhicule électrique.

Le véhicule VE est relié à la station ou borne de recharge 100, par exemple par l'intermédiaire d'une prise conforme à la norme CEI 62196 Type 2.

Dans la Fig. 1, le lien de connexion de proximité PP, le lien de contrôle CP et les connexions de l'alimentation PW sont représentées, le lien de mise à la terre n'est pas représenté par souci de simplification.

La borne de recharge 100 comporte un dispositif de détection d'une coupure d'une connexion entre une borne de recharge et un véhicule électrique selon la présente invention.

La borne de recharge est connectée à un réseau de fourniture en énergie électrique MPW.

Lorsque la prise femelle de la borne de recharge est fixée directement sur la borne, la liaison de connexion PP est présente, lorsque la prise femelle de la borne de recharge est au bout d'un câble flexible attaché de manière permanente à la borne par l'autre extrémité, la liaison de connexion PP n'est pas présente.

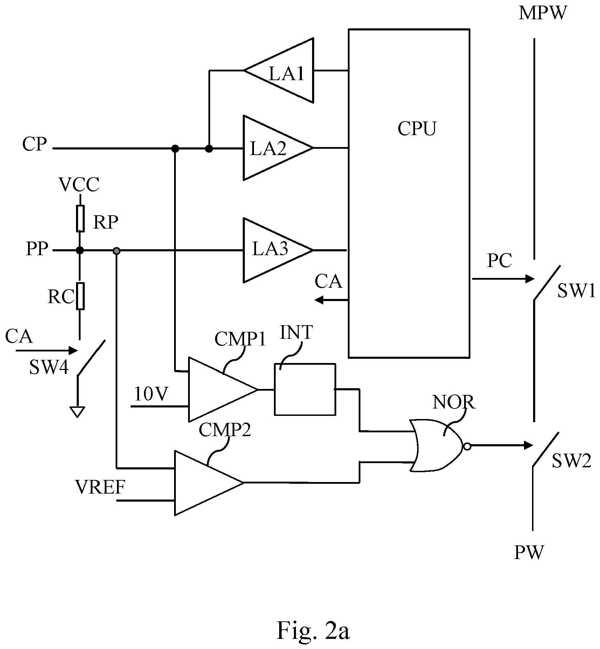

La Fig. 2a représente un schéma bloc d'un premier exemple de réalisation d'un dispositif de détection d'une coupure d'une connexion entre une borne de recharge et un véhicule électrique.

La Fig. 2a comporte un microcontrôleur CPU, deux résistances RP et RC, trois adaptateurs de niveau LA1, LA2 et LA3, deux comparateurs CMP1 et CMP2, un intégrateur INT, une fonction logique non ou NOR et trois interrupteurs SW1, SW2 et SW4.

Le lien de contrôle CP est relié à la sortie de l'adapteur de niveau LA1 et à l'entrée de l'adaptateur de niveau LA2 et au comparateur CMP1.

Le lien de mise à la terre n'est pas représenté par souci de simplification.

L'entrée de l'adaptateur de niveau LA1 est reliée à une sortie du microcontrôleur CPU et la sortie de l'adaptateur de niveau LA2 est reliée à une entrée du microcontrôleur CPU.

Le signal PP est relié à une entrée de l'adaptateur de niveau LA3 dont la sortie est reliée à une entrée du microcontrôleur CPU et au comparateur CMP2.

Le signal PP est en outre relié à une première terminaison de la résistance notée RP et à une première terminaison de la résistance RC.

Une seconde terminaison de la résistance RC est reliée à une première terminaison de l'interrupteur SW4.

Une seconde terminaison de l'interrupteur SW4 est reliée à la masse du dispositif de détection d'une coupure d'une connexion entre une borne de recharge et un véhicule électrique et une seconde terminaison de la résistance RP est reliée à l'alimentation électrique du dispositif de détection d'une coupure d'une connexion entre une borne de recharge et un véhicule électrique.

L'interrupteur SW4 est commandé par le signal CA délivré par le microcontrôleur CPU.

La valeur du signal CA est fonction du fait que la prise femelle de la station de recharge est fixée directement sur la station de recharge ou est au bout d'un câble flexible attaché de manière permanente à la borne de recharge par l'autre extrémité. Le comparateur de niveau CMP1 compare la tension du signal sur le lien de contrôle CP à une tension par exemple égale à 10 Volts.

Lorsque la tension du signal sur le lien de contrôle CP est supérieure à 10 Volts, le signal en sortie du comparateur CMP1 est au niveau haut.

La sortie du comparateur CMP1 est reliée à l'intégrateur INT qui intègre le signal délivré par le comparateur CMP1 avec une constante de temps par exemple égale à 10 ms. La sortie de l'intégrateur INT est reliée à une entrée de la fonction logique non ou NOR.

Le comparateur de niveau CMP2 compare la tension du signal PP à une tension de référence VREF. La tension de référence est définie en fonction de la valeur d'une résistance RP comprise dans la prise femelle ou dans la station de recharge et la résistance RC comprise dans le câble de recharge. Par exemple, si la résistance RC comprise dans le câble de recharge a une valeur par exemple inférieure à 4500 Ohm, la sortie du comparateur CMPT2 est au niveau haut. La valeur de la résistance RC est par exemple donnée dans le tableau B2 de la norme IEC61851-1.

La sortie du comparateur CMP2 est reliée à une entrée de la fonction logique non ou NOR.

La sortie de la fonction logique non ou NOR commande le relai SW2.

Le microcontrôleur CPU commande le relai SW1 par le signal PC.

Une première terminaison du relai SW1 est reliée au réseau de fourniture en énergie électrique MPW. Une seconde terminaison du relai SW1 est reliée à une première terminaison du relai SW2. La seconde terminaison du relai SW2 est reliée à l'alimentation PW.

Selon l'invention, le microcontrôleur CPU monitore la tension sur le lien de contrôle CP, détecte une déconnexion de la fiche male avec la borne de recharge et interrompt la fourniture en énergie électrique au véhicule électrique en ouvrant le relai SW1. Le comparateur COMP1, l'intégrateur INT monitorent la tension sur le lien de contrôle CP, détectent une déconnexion de la fiche mâle de la borne de recharge et interrompent la fourniture en énergie électrique au véhicule électrique en ouvrant le relai SW2.

L'utilisation de deux relais en série, ainsi que la duplication de la détection d'une déconnexion de la fiche mâle avec la borne de recharge, garantit dans toutes conditions, par exemple lorsque le microcontrôleur CPU, de par d'autres traitements effectués, ne commande pas une ouverture du relais SW1 rapidement ou lorsqu'une défaillance du microcontrôleur CPU survient, qu'un utilisateur puisse être en contact avec l'énergie électrique fournie au véhicule électrique.

La liaison de connexion PP est en outre utilisée à la fois par le microcontrôleur CPU et le comparateur CMP2, l'intégrateur INT et la fonction logique non ou NOR pour ouvrir les relais SW1 et SW2.

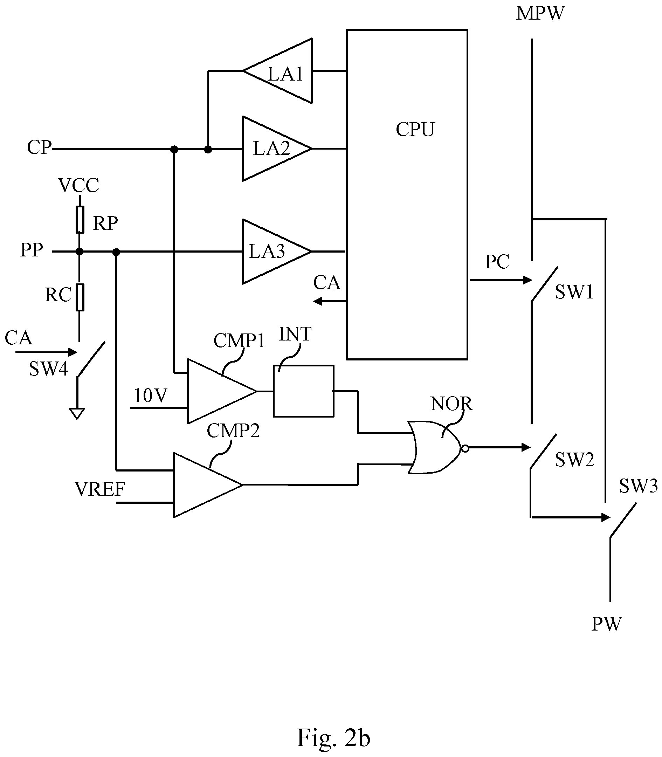

La Fig. 2b représente un schéma bloc d'un second exemple de réalisation d'un dispositif de détection d'une coupure d'une connexion entre une borne de recharge et un véhicule électrique.

La Fig. 2b comporte un microcontrôleur CPU, trois adaptateurs de niveau LA1, LA2 et LA3, deux comparateurs CMP1 et CMP2, un intégrateur INT, une fonction logique non ou NOR et quatre interrupteurs SW1, SW2, SW3 et SW4.

Le lien de contrôle CP est relié à la sortie de l'adapteur de niveau LA1 et à l'entrée de l'adaptateur de niveau LA2 et au comparateur CMP1.

Le lien de mise à la terre n'est pas représenté par souci de simplification.

L'entrée de l'adaptateur de niveau LA1 est reliée à une sortie du microcontrôleur CPU et la sortie de l'adaptateur de niveau LA2 est reliée à une entrée du microcontrôleur CPU.

Le signal PP est relié à une entrée de l'adaptateur de niveau LA3 dont la sortie est reliée à une entrée du microcontrôleur CPU et au comparateur CMP2.

Le signal PP est en outre relié à une première terminaison de la résistance notée RP et à une première terminaison de la résistance RC.

Une seconde terminaison de la résistance RC est reliée à une première terminaison de l'interrupteur SW4.

Une seconde terminaison de l'interrupteur SW4 est reliée à la masse du dispositif de détection d'une coupure d'une connexion entre une borne de recharge et un véhicule électrique et une seconde terminaison de la résistance RP est reliée à l'alimentation électrique du dispositif de détection d'une coupure d'une connexion entre une borne de recharge et un véhicule électrique.

L'interrupteur SW4 est commandé par le signal CA délivré par le microcontrôleur CPU.

La valeur du signal CA est fonction du fait que la prise femelle de la station de recharge est fixée directement sur la station de recharge ou est au bout d'un câble flexible attaché de manière permanente à la borne par l'autre extrémité.

Le comparateur de niveau CMP1 compare la tension du signal sur le lien de contrôle CP à une tension par exemple égale à 10 Volts.

Lorsque la tension du signal sur le lien de contrôle CP est supérieure à 10 Volts, le signal en sortie du comparateur CMP1 est au niveau haut.

La sortie du comparateur CMP1 est reliée à l'intégrateur INT qui intègre le signal délivré par le comparateur CMP1 avec une constante de temps par exemple égale à 10 ms. La sortie de l'intégrateur INT est reliée à une entrée de la fonction logique non ou NOR.

Le comparateur de niveau CMP2 compare la tension du signal PP à une tension de référence VREF. La tension de référence est définie en fonction de la valeur d'une résistance RP comprise dans la prise femelle ou dans la station de recharge et de la résistance RC comprise dans le câble de recharge. Par exemple, si la résistance RC comprise dans le câble de recharge a une valeur par exemple inférieure à 4500 Ohm, la sortie du comparateur CMPT2 est au niveau haut. La valeur de la résistance RC est par exemple donnée dans le tableau B2 de la norme IEC61851-1.

La sortie du comparateur CMP2 est reliée à une entrée de la fonction logique non ou NOR.

La sortie de la fonction logique non ou NOR commande le relai SW2.

Le microcontrôleur CPU commande le relai SW1 par le signal PC.

Une première terminaison du relai SW1 est reliée au réseau de fourniture en énergie électrique MPW et à une première terminaison du relai SW3. Une seconde terminaison du relai SW1 est reliée à une première terminaison du relai SW2. La seconde terminaison du relai SW2 commande le commutateur SW3. Une seconde terminaison du relai SW3 est reliée à l'alimentation PW.

Selon l'invention, le microcontrôleur CPU monitore la tension sur le lien de contrôle CP, détecte une déconnexion de la fiche mâle avec la borne de recharge et interrompt la fourniture en énergie électrique au véhicule électrique en ouvrant le relai SW1. Le comparateur COMP1, l'intégrateur INT monitorent la tension sur le lien de contrôle CP, détectent une déconnexion de la fiche mâle de la borne de recharge et interrompent la fourniture en énergie électrique au véhicule électrique en ouvrant le relai SW2.

L'utilisation de deux relais en série ainsi que la duplication de la détection d'une déconnexion de la fiche mâle avec la borne de recharge, garantit dans toutes conditions, par exemple lorsque le microcontrôleur CPU, de par d'autres traitements en cours d'exécution ne commande pas une ouverture du relais SW1 rapidement ou lorsqu'une défaillance du microcontrôleur CPU survient, qu'un utilisateur puisse être en contact avec l'énergie électrique fournie au véhicule électrique.

La liaison de connexion PP est en outre utilisée à la fois par le microcontrôleur CPU et le comparateur CMP2, l'intégrateur INT et la fonction logique non ou NOR pour ouvrir les commutateurs SW1 et SW2.

Le commutateur SW3 est commandé par la fermeture simultanée des commutateurs SW1 et SW2. Le commutateur SW3 peut par exemple être un contacteur ICT40A commercialisé par la société Schneider, ou un contacteur ESC440 commercialisé par la société Hager pour une alimentation triphasée.

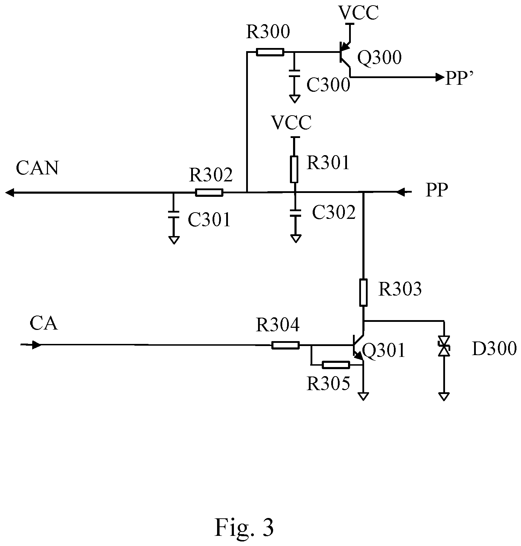

La Fig. 3 représente un exemple de réalisation d'un circuit de gestion de la présence ou non d'un lien de connexion PP permettant la signalisation d'une pré-insertion d'une prise.

La Fig. 3 comporte deux transistors Q300 et Q301, six résistances notées R300, R301, R302, R303, R304 et R305, deux condensateurs C301 et C302, et un circuit écrêteur D300.

Le lien de connexion PP, lorsqu'il est présent, est relié à une première terminaison de la résistance R300, à une première terminaison de la résistance R301, à une première terminaison de la résistance R302, à une première terminaison de la résistance R303 et à une première terminaison du condensateur C302.

Le signal CA est un signal délivré par le microcontrôleur CPU qui indique si un lien de connexion PP permettant la signalisation d'une pré-insertion d'une prise est présent ou pas.

Le signal CA est relié à une première terminaison de la résistance R304. Une seconde terminaison de la résistance R304 est reliée à la base du transistor NPN Q301 et à une première terminaison de la résistance R305.

Une seconde terminaison de la résistance R305 est reliée à la masse et à l'émetteur du transistor Q301.

Le collecteur du transistor Q301 est relié au circuit écrêteur D300 et à une seconde terminaison de la résistance R303.

Une seconde terminaison du condensateur C302 est reliée à la masse.

Une seconde terminaison de la résistance R302 est reliée à une première terminaison du condensateur C302 dont la seconde terminaison est reliée à la masse et délivre un signal CAN au microprocesseur CPU non représenté dans les Figs. 2a et 2b.

Une seconde terminaison de la résistance R301 est reliée à l'alimentation continue du dispositif de détection d'une coupure d'une connexion entre une borne de recharge et un véhicule électrique.

Une seconde terminaison de la résistance R300 est reliée à la base du transistor PNP Q300 et à une première terminaison du condensateur C300 dont la seconde terminaison est reliée à la masse. L'émetteur du transistor Q300 est relié à l'alimentation continue du dispositif de détection d'une coupure d'une connexion entre une borne de recharge et un véhicule électrique.

Le collecteur Q300 délivre le signal PP' qui est le signal de sortie du comparateur CMP2.

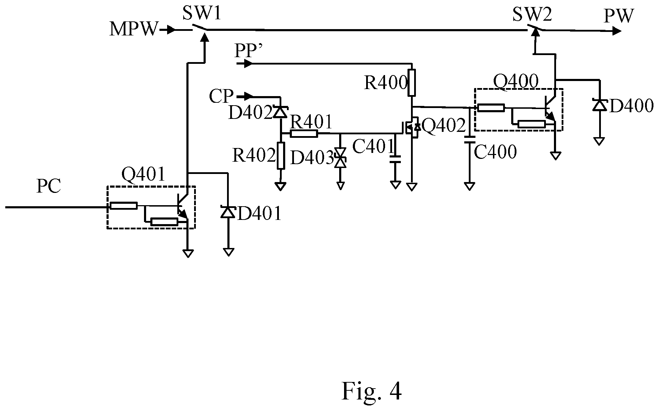

La Fig. 4 représente un exemple de réalisation d'un circuit de détection d'une coupure d'une connexion entre une borne de recharge et un véhicule électrique. Dans l'exemple de la Fig. 4, le circuit de détection d'une coupure d'une connexion entre une borne de recharge et un véhicule électrique comporte trois transistors Q400, Q401 et Q402, trois diodes D400, D401 et D402, un circuit écrêteur D403, trois résistances R400, R401 et R402, deux condensateurs C400 et C401 et deux relais SW1 et SW2.

Le signal de commande PC du relai SW1 délivré par le microcontrôleur CPU est appliqué à la base du transistor Q401. L'émetteur du transistor Q401 est relié à la masse et le collecteur du transistor Q401 commande le relai SW1 et est relié à la cathode de la diode Zener D401. L'anode de la diode Zener D401 est reliée à la masse.

La tension d'avalanche de la diode D401 est par exemple de 39 Volts.

Le signal PP' est appliqué sur une première terminaison de la résistance R400. Une seconde terminaison de la résistance R400 est reliée au drain du transistor MOSFET Q402 et à la grille du transistor numérique Q400.

Le lien de connexion CP est relié à la cathode de la diode Zener D402 dont la tension d'avalanche est par exemple de 9,1 Volts.

L'anode de la diode Zener D402 est reliée à une première terminaison de la résistance R401 et à une première terminaison de la résistance R402.

Une seconde terminaison de la résistance R402 est reliée à la masse.

Une seconde terminaison de la résistance R401 est reliée à une première terminaison du circuit écrêteur D403, à une première terminaison du condensateur C401 et à la grille du transistor MOSFET Q402.

Une seconde terminaison du circuit écrêteur D403, une seconde terminaison du condensateur C401 et la source du transistor MOSFET Q402 sont reliées à la masse. L'émetteur du transistor Q400 est relié à la masse et le collecteur du transistor Q400 est relié à la cathode de la diode Zener D400 et commande le relai SW2.

L'anode de la diode Zener D400 est reliée à la masse. La tension d'avalanche de la diode D400 est par exemple de 39 volts.

Le comparateur CMP1 et la tension de 10V sont constitués des résistances R401 et R402, du limiteur de tension D402, du condensateur C401.

L'intégrateur INT est constitué du transistor Q402, de la résistance R400 et du condensateur C400.

La fonction logique non ou NOR est constituée du transistor Q400.

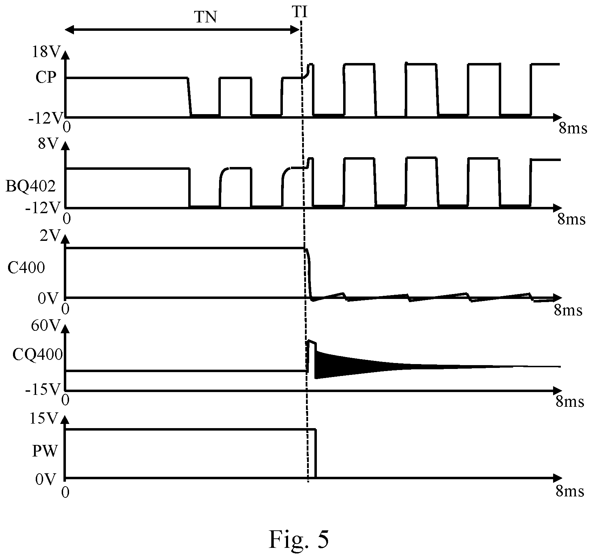

La Fig. 5 représente un exemple de signaux électriques du circuit de détection d'une coupure d'une connexion entre une borne de recharge et un véhicule électrique.

Les tensions sur le lien de contrôle CP, sur la base du transistor Q402, aux bornes du condensateur C400, sur le collecteur du transistor CQ440 et la tension délivrée par l'alimentation PW sont représentées dans la Fig. 5. Dans l'exemple de la Fig. 5, l'alimentation MPW de 230V AC est remplacée par une alimentation continue 12VDC.

Les axes des abscisses représentent le temps en millisecondes et les axes des ordonnées représentent la tension en Volts.

Le signal délivré par le lien de contrôle CP est un signal périodique qui, dans un fonctionnement normal, prend la valeur de 6 volts et -12Volts.

La période de temps correspondant à un fonctionnement normal est notée TN en Fig. 5.

Le signal sur la base du transistor Q402 composant de l'intégrateur INT prend la valeur de 0 volts et -12Volts pendant la période de temps TN.

La tension aux bornes du condensateur C400 correspondant à la sortie de l'intégrateur INT est constante et égale à 1,6V et la tension sur le collecteur du transistor Q400 est égale à 8 volts, tension permettant la fermeture du relai SW2 et la fourniture en énergie électrique au véhicule électrique.

A partir de l'instant TI, une déconnexion du lien PE entre le véhicule électrique et la borne de recharge est simulée. La tension sur le lien de contrôle CP prend une valeur supérieure à la valeur de tension correspondant à un fonctionnement normal.

Cette augmentation de tension se traduit par une commutation du transistor Q402 qui vient court-circuiter le signal sur la base du transistor numérique Q400 ; ainsi la tension aux bornes du condensateur C400 tombe à 0V. Ceci provoque l'ouverture du transistor Q400 et donc l'interruption de la circulation du courant dans la bobine de commande du commutateur SW2. L'interruption du courant dans la bobine du relai SW2 génère une surtension sur le collecteur du transistor Q400 qui est écrêtée par la diode D400 à une tension par exemple de 39V de manière à protéger le transistor Q400. Le commutateur SW2 reste passant tant que l'énergie stockée dans sa bobine de commande n'est pas dissipée. Une fois l'énergie suffisante au maintien du pilotage du relai SW2 évacuée, le commutateur SW2 s'ouvre et par conséquent l'alimentation MPW est interrompue. La tension sur le collecteur de Q400 devient inférieure à la tension d'avalanche de la diode D400 et la diode D400 ne conduit plus. Quand la diode D400 ne conduit plus, un circuit RLC oscillant, composé de la bobine du commutateur SW2, de sa résistance série et de la capacité parasite de la diode D400, dissipe le reste d'énergie présent dans la bobine du relai SW2, d'où l'oscillation présente sur le signal CQ400.

## Revendications

1. Dispositif de détection d'une coupure et/ou d'anomalie d'une connexion entre une borne de recharge et un véhicule électrique, la connexion comportant au moins un lien de contrôle (CP), un lien de mise à la terre, de broches d'alimentation, le lien de contrôle permettant la signalisation d'une post-insertion, le dispositif de détection comportant :
- un microcontrôleur (CPU) configuré pour mesurer la tension sur le lien de contrôle et pour commander la fermeture ou l'ouverture d'un premier interrupteur (SW1) afin d'autoriser ou non la fourniture d'énergie électrique par les broches d'alimentation, **caractérisé en ce que** le dispositif de détection comporte :
- un circuit électronique, (CMP1, CMP2, INT, NOR) distinct du microcontrôleur, pour mesurer la tension sur le lien de contrôle et commander la fermeture ou l'ouverture d'un second interrupteur (SW2) pour autoriser ou non la fourniture en énergie électrique par les broches d'alimentation, lesdits premier et second interrupteurs étant montés en série.

2. Dispositif selon la revendication 1, **caractérisé en ce que** la connexion entre la borne de recharge et le véhicule électrique comporte en outre un lien de connexion de proximité permettant une signalisation d'une pré-insertion et **en ce que** :
- le microcontrôleur est configuré pour mesurer la tension sur le lien de connexion de proximité et pour commander la fermeture ou l'ouverture du premier interrupteur pour autoriser ou non la fourniture en énergie électrique par les broches d'alimentation,
- le circuit électronique mesure la tension sur le lien de connexion de proximité et commande la fermeture ou l'ouverture du second interrupteur pour autoriser ou non la fourniture en énergie électrique par les broches d'alimentation.

3. Dispositif selon la revendication 1 ou 2, **caractérisé en ce que** lesdits premier et second interrupteurs montés en série commandent un troisième interrupteur pour autoriser ou non la fourniture en énergie électrique par les broches d'alimentation.

4. Dispositif selon l'une quelconque des revendications 2 à 3, **caractérisé en ce que** le circuit électronique comporte un premier comparateur pour comparer le signal du lien de contrôle à une première tension, un second comparateur pour comparer le signal sur le lien de connexion de proximité à une seconde tension et une fonction logique non ou pour combiner les signaux de sortie des premier et second comparateurs.

5. Dispositif selon l'une quelconque des revendications 1 à 4, **caractérisé en ce que** le dispositif de détection comporte un autre interrupteur, l'ouverture et la fermeture de l'autre interrupteur étant commandées par le microcontrôleur en fonction du fait que la prise femelle de la borne de recharge est fixée directement sur la borne de recharge ou est au bout d'un câble flexible attaché de manière permanente à la borne de recharge par l'autre extrémité.

## Patentansprüche

1. Vorrichtung zur Erkennung einer Unterbrechung und/oder einer Anomalie einer Verbindung zwischen einer Ladestation und einem Elektrofahrzeug, wobei die Verbindung mindestens einen Steueranschluss (CP), einen Erdungsanschluss, Versorgungspins umfasst, wobei der Steueranschluss die Signalisierung eines Zustands nach dem Einstecken ermöglicht, wobei die Vorrichtung zur Erkennung umfasst:
- einen Mikrocontroller (CPU), der dazu ausgestaltet ist, die Spannung an dem Steueranschluss zu messen und das Schließen oder das Öffnen eines ersten Schalters (SW1) zu steuern, um das Abgeben von elektrischer Energie durch die Versorgungspins zuzulassen oder nicht, **dadurch gekennzeichnet, dass** die Vorrichtung zur Erkennung umfasst:
- eine elektronische Schaltung (CMP1, CMP2, INT, NOR), die von dem Mikrocontroller verschieden ist, um die Spannung an dem Steueranschluss zu messen und das Schließen oder das Öffnen eines zweiten Schalters (SW2) zu steuern, um das Abgeben von elektrischer Energie durch die Versorgungspins zuzulassen oder nicht, wobei der erste und der zweite Schalter in Reihe geschaltet sind.

2. Vorrichtung nach Anspruch 1, **dadurch gekennzeichnet, dass** die Verbindung zwischen der Ladestation und dem Elektrofahrzeug ferner einen Proximity-Verbindungsanschluss umfasst, der eine Signalisierung eines Zustands vor dem Einstecken ermöglicht, und dadurch, dass:
- der Mikrocontroller dazu ausgestaltet ist, die Spannung an dem Proximity-Verbindungsanschluss zu messen und das Schließen oder das Öffnen des zweiten Schalters zu steuern, um das Abgeben von elektrischer Energie durch die Versorgungspins zuzulassen oder nicht,
- die elektronische Schaltung die Spannung an dem Proximity-Verbindungsanschluss misst und das Schließen oder das Öffnen des zweiten Schalters steuert, um das Abgeben von elektrischer Energie durch die Versorgungspins zuzulassen oder nicht.

3. Vorrichtung nach Anspruch 1 oder 2, **dadurch gekennzeichnet, dass** die ersten und zweiten Schalter, die in Reihe geschaltet sind, einen dritten Schalter steuern, um das Abgeben von elektrischer Energie durch die Versorgungspins zuzulassen oder nicht.

4. Vorrichtung nach einem der Ansprüche 2 bis 3, **dadurch gekennzeichnet, dass** die elektrische Schaltung einen ersten Komparator, um das Signal des Steueranschlusses mit einer ersten Spannung zu vergleichen, einen zweiten Komparator, um das Signal an dem Proximity-Verbindungsanschluss mit einer zweiten Spannung zu vergleichen, und eine NOR-Logikfunktion, um die Ausgangssignale der ersten und zweiten Komparatoren zu kombinieren, umfasst.

5. Vorrichtung nach einem der Ansprüche 1 bis 4, **dadurch gekennzeichnet, dass** die Vorrichtung zur Erkennung einen weiteren Schalter umfasst, wobei das Öffnen und das Schließen des weiteren Schalters von dem Mikrocontroller in Abhängigkeit von der Tatsache gesteuert werden, dass die Buchse der Ladestation direkt an der Ladestation befestigt ist oder am Ende eines flexiblen Kabels ist, das über das andere Ende dauerhaft mit der Ladestation verbunden ist.

## Claims

1. Device for detecting a break and/or an anomaly in a connection between a charging terminal and an electric vehicle, the connection comprising at least a control link (CP), an earthing link and power supply pins, the control link making it possible to signal a post-insertion, the detection device comprising:
- a microcontroller (CPU) configured to measure the voltage on the control link and to control the closing or opening of a first switch (SW1) in order to authorize or not authorize the supply of electrical energy by the power supply pins, **characterized in that** the detection device comprises:
- an electronic circuit (CMP1, CMP2, INT, NOR) which is distinct from the microcontroller, for measuring the voltage on the control link and to control the closing or opening of a second switch (SW2) in order to authorize or not authorize the supply of electrical energy by the power supply pins, said first switch and second switch being connected in series.

2. Device according to Claim 1, **characterized in that** the connection between the charging terminal and the electric vehicle further comprises a proximity connection link making it possible to signal a pre-insertion and **in that**:
- the microcontroller is configured to measure the voltage on the proximity connection link and to control the closing or opening of the first switch in order to authorize or not authorize the supply of electrical energy by the power supply pins,
- the electronic circuit measures the voltage on the proximity connection link and controls the closing or opening of the second switch in order to authorize or not authorize the supply of electrical energy by the power supply pins.

3. Device according to Claim 1 or 2, **characterized in that** said first switch and second switch connected in series control a third switch in order to authorize or not authorize the supply of electrical energy by the power supply pins.

4. Device according to either one of Claims 2 and 3, **characterized in that** the electronic circuit comprises a first comparator for comparing the signal of the control link with a first voltage, a second comparator for comparing the signal on the proximity connection link with a second voltage and a NOR logic function for combining the output signals of the first comparator and second comparator.

5. Device according to any one of Claims 1 to 4, **characterized in that** the detection device comprises another switch, the opening and closing of the other switch being controlled by the microcontroller depending on whether the socket of the charging terminal is attached directly to the charging terminal or is at the end of a flexible cable permanently attached to the charging terminal by the other end.
